# EUROPÄISCHE PATENTSCHRIFT

(11) **EP 0 463 188 B1**
(45) Veröffentlichungstag und Bekanntmachung des Hinweises auf die Patenterteilung: **06.03.1996**
(21) Anmeldenummer: 90111589.9
(22) Anmeldetag: 19.06.1990
(51) Int. Cl.: H03K 17/95

(54) **Induktiver Annäherungsschalter mit geringer Temperaturabhängigkeit**
Inductive proximity switch with low sensitivity to temperature variations
Commutateur de proximité inductif peu sensible aux variations de température

(43) Veröffentlichungstag der Anmeldung: 02.01.1992
(73) Patentinhaber: SIEMENS AKTIENGESELLSCHAFT, D-80333 München (DE)
(72) Erfinder: Hödlmayr, Franz, Dipl.-Ing., D-8000 München 90 (DE)

(56) Entgegenhaltungen:
- EP-A- 0 207 372
- DE-A- 3 248 169
- DE-A- 3 513 403
- DE-A- 3 606 586
- PATENT ABSTRACTS OF JAPAN, vol. 12, no. 481 (E-694)[3328], 15. Dezember 1988 & JP-A-63 198 414

## Beschreibung

Die Erfindung betrifft einen induktiven Annäherungsschalter, umfassend einen Anwesenheitsindikator, der einen Oszillator mit Schwingkreis und einen Oszillatorverstärker enthält und der eine Temperaturabhängigkeit aufweist, durch die die durch die Temperaturabhängigkeit der Güte des Schwingkreises bedingte Temperaturabhängigkeit des Schaltpunktes des induktiven Näherungsschalters ausgleichbar ist; einen dem Oszillator zugeordneten Demodulator; einen vom Anwesenheitsindikator gesteuerten Schaltverstärker; und einen vom Anwesenheitsindikator über den Schaltverstärker steuerbaren elektronischen Schalter.

Induktive Annäherungsschalter sind prinzipiell bekannt und unter anderem in der DE-OS 37 22 335 sowie den darin genannten Schriften beschrieben. Bei diesen bekannten induktiven Annäherungsschaltern ist der Schaltabstand abhängig von der Güte des Resonanzkreises des Oszillators. Die Güte des Resonanzkreises, der aus einer Spule mit Ferritkern und einer Kapazität besteht, ist unter anderem vom Spulenverlustfaktor abhängig. Wie dem Datenbuch 1990/91 der Fa. Siemens, "Ferrite und Zubehör", insbesondere Seite 35 zu entnehmen ist, ist der Spulenverlustfaktor temperaturabhängig. Für den in induktiven Annäherungsschaltern einsetzbaren Werkstoff N48 der Fa. Siemens weist der bezogene Verlust faktor innerhalb des für induktive Annäherungsschalter interessanten Betriebstemperaturbereiches ein Minimum auf, d. h. oberhalb und unterhalb einer bestimmten Temperatur nimmt der bezogene Verlustfaktor zu.

Bei aus der DE-A1-32 48 169 bekannten induktiven Annäherungsschaltern wird die Temperaturabhängigkeit des Schaltabstandes durch zusätzliche Bauelemente, wie z. B. Heißleiter, Kaltleiter, Dioden oder Widerstände teilweise kompensiert. Solche Kompensationsmaßnahmen sind, zumindest im Hinblick auf einen möglichst einfachen Schaltungsaufbau mit Hilfe der monolithischen Integration aufwendig und die erzielten Verbesserungen der Temperaturabhängigkeit sind relativ gering. Mit solchen bekannten Maßnahmen kann ein Abweichen des Schaltabstandes von ca. ±10% über einen Temperaturbereich von ca. 100 Grad erzielt werden.

Der Erfindung liegt die Aufgabe zugrunde, einen induktiven Annäherungsschalter mit einstellbarer Hysterese und einem einen Oszillator enthaltenden Anwesenheitsindikator anzugeben, dessen Schaltabstand erheblich weniger temperaturabhängig ist. Die Lösung soll außerdem monolithisch integrierbar sein.

Diese Aufgabe wird bei einem eingangs genannten induktiven Näherungsschalter dadurch gelöst, daß der Oszillatorverstärker eine Stromspiegelschaltung umfaßt und eine Darlington-Stufe, daß durch die Darlington-Stufe in den gesteuerten Zweig der Stromspiegelschaltung des Oszillatorverstärkers ein Strom eingekoppelt wird und daß die Darlington-Stufe von einem am Oszillator abgreifbaren Potential steuerbar ist; oder alternativ dadurch, daß der Demodulator eine Stromspiegelschaltung umfaßt und eine Darlington-Stufe, daß durch die Darlington-Stufe in den gesteuerten Zweig der Stromspiegelschaltung des Demodulators ein Strom eingekoppelt wird und daß die Darlington-Stufe von einem am Oszillator abgreifbaren Potential steuerbar ist. Günstige Ausgestaltungen sind Gegenstand von Unteransprüchen.

Kern der Erfindung ist es, in einem induktiven Annäherungsschalter eine Oszillator/Demodulator-Schaltung zu verwenden, die so ausgelegt ist, daß ihre Temperaturcharakteristik die Temperaturcharakteristik des an die Oszillator/Demodulator-Schaltung angeschlossenen, vom Temperaturverhalten des verwendeten Ferritkerns abhängigen Schwingkreis kompensiert. Das wird dadurch erreicht, daß die Temperaturcharakteristik der Oszillator/Demodulator-Schaltung in etwa den achsengespiegelten Verlauf der Temperaturcharakteristik einer mit Kupferdraht auf einen Ferritkern gewickelten Spule darstellt. Die hierzu erforderlichen schaltungstechnischen Maßnahmen können entweder im Oszillatorverstärker oder im Demodulator, jedoch auch sowohl im Oszillatorverstärker als auch im Demodulator vorgenommen werden. Da der Schaltpunkt des induktiven Annäherungsschalters, also der Abstand zwischen einem Metallteil und der Spule des Anwesenheitsindikators, von der Güte des Schwingkreises, von der Dimensionierung der Oszillatorverstärkerschaltung und von der Auslegung der Demodulatorschaltung abhängt, die Temperaturabhängigkeit der Güte des Schwingkreises jedoch durch den gewählten Ferritkern weitgehend festgelegt ist, soll erfindungsgemäß durch Anpassung der Tempoeraturabhängigkeit des Schaltpunktes, die durch die Oszillatorverstärkerschaltung und/oder durch die Demodulatorschaltung gegeben ist, der Temperaturabhängigkeit des Schaltpunktes, die durch den Schwingkreis gegeben ist, entgegengewirkt werden.

Aus der EP-A1-0172 393 und aus der EP-A1-0 207 372 ist eine Oszillator/Demodulator-Schaltungsanordnung für einen induktiven Annäherungsschalter bekannt. Nachfolgend werden erfindungsgemäße Varianten dieser bekannten Oszillator/Demodulator-Schaltungsanordnung beschrieben. Selbstverständlich hat der Fachmann die Möglichkeit, auch andere Oszillator- und/oder Demodulator-Schaltungen abzuwandeln, um einen erfindungsgemäßen induktiven Annäherungsschalter zu realisieren.

Im folgenden wird die Erfindung anhand der Figuren näher erläutert.

Es zeigt:
- Figur 1: ein Blockschaltbild eines induktiven Annäherungsschalters 1, wie u.a. in der DE-OS 3 722 335 dargestellt;
- Figur 2: detailliert einen Ausschnitt aus dem induktiven Annäherungsschalter 1 nach Figur 1, nämlich eine erfindungsgemäß abgewandelte bekannte Oszillator/Demodulator-Schaltung zur Realisierung eines erfindungsgemäßen induktiven Annäherungsschalters;
- Figur 3: detailliert einen Ausschnitt aus dem induktiven Annäherungsschalter 1 nach Figur 1, nämlich eine erfindungsgemäß abgewandelte Demodulatorschaltung zur Verwendung mit einer beliebigen Oszillatorschaltung OA, FE, und
- Figur 4: detailliert einen Ausschnitt aus dem induktiven Annäherungsschalter 1 nach Figur 1, nämlich eine erfindungsgemäß abgewandelte Oszillatorschaltung, die mit einer beliebigen Demodulatorschaltung D kombiniert werden kann.

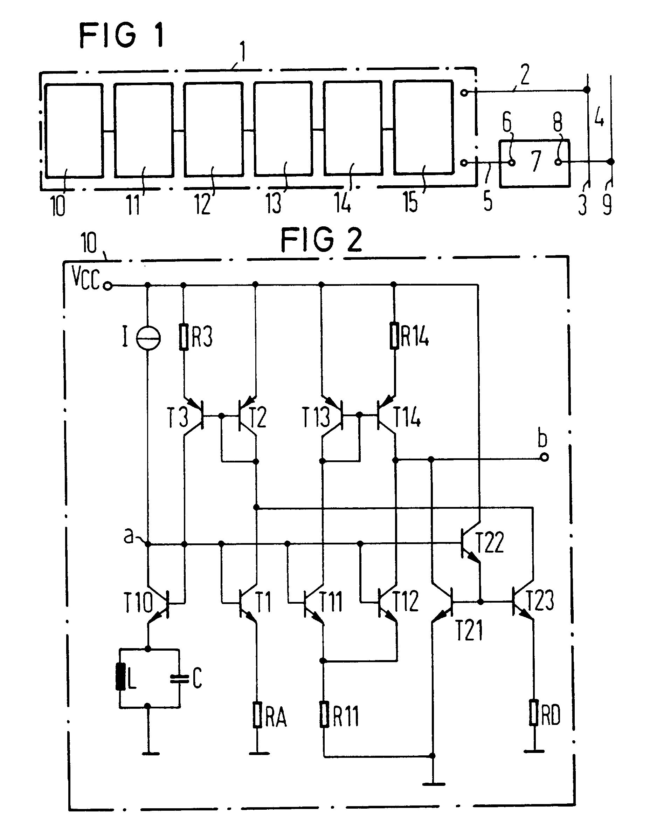

Der in Figur 1 mit Hilfe eines Blockschaltbildes dargestellte induktive Annäherungsschalter 1 arbeitet berührungslos, d.h., er spricht z.B. auf ein sich annäherndes, nicht dargestelltes Metallteil an, und ist im dargestellten Ausführungsbeispiel über einen Außenleiter 2 an einen Pol 3 einer Betriebsspannungsquelle 4 und nur über einen weiteren Außenleiter 5 an einen Anschluß 6 eines Verbrauchers 7 angeschlossen, während der andere Anschluß 8 des Verbrauchers 7 an den anderen Pol 9 der Betriebsspannungsquelle 4 angeschlossen ist. Der dargestellte induktive Annäherungsschalter 1 ist also in bekannter Weise über insgesamt nur zwei Außenleiter 2,5 einerseits an die Betriebsspannungsquelle 4 und andererseits an den Verbraucher 7 angeschlossen. Selbstverständlich sind auch induktive Annäherungsschalter 1 bekannt, die zur Bereitstellung ihrer Versorgungsspannung parallel zum Verbraucher 7 über einen dritten Leiter an den anderen Pol 9 der Betriebsspannungsquelle 4 angeschlossen sind.

Wie Figur 1 zeigt, besteht der dargestellte induktive Annäherungsschalter 1 in seinem grundsätzlichen Aufbau aus einem von außen beeinflußbaren Anwesenheitsindikator 10, in diesem Falle einem Oszillator mit zugeordnetem Demodulator, einem dem Anwesenheitsindikator 10 nachgeordneten Schaltverstärker 11, einem von dem Anwesenheitsindikator 10 über den Schaltverstärker 11 steuerbaren elektronischen Schalter 14, z.B. einem Thyristor oder einem Transistor, einer Speiseschaltung 13 zur Bereitstellung einer Versorgungsspannung für den Anwesenheitsindikator 10 und den Schaltverstärker 11 und einer Einschaltimpulse verhindernden Verzögerungsschaltung 12. Eingangsseitig ist noch eine Gleichrichterbrücke 15 vorgesehen, falls es sich bei der Betriebsspannungsquelle 4 um eine Wechselspannungsquelle handelt.

Die Lehre der Erfindung beschäftigt sich nicht mit der Ausgestaltung des Schaltverstärkers 11, des steuerbaren elektronischen Schalters 12, der Speiseschaltung 13, der Verzögerungsschaltung 14 und der Gleichrichterbrücke 15, so daß insoweit die Figuren Details nicht zeigen. Für den induktiven Annäherungsschalter 1 mögliche und bevorzugte Ausführungsformen dieser Schaltungsteile können der DE-OS 3 722 335 sowie den darin genannten Schriften und auch dem Datenbuch 1989/90 der Firma Siemens, ICs für Industrielle Anwendungen, Seiten 798 bis 812 sowie den dort beschriebenen integrierten Bausteinen TCA205, TCA305 und TCA355 entnommen werden.

Die in FIG 2 gezeigte Schaltung entspricht, abgesehen von Transistoren T21,T22 und T23 sowie einem Widerstand RD weitgehend der aus der EP-A1-0 172 393 und aus der EP-A1-0 207 372 bekannten Oszillator/Demodulator-Schaltung. Diese Oszillator/Demodulator-Schaltung enthält eine Konstantstromquelle I, die zwischen ein Versorgungspotential V_{CC} und einen Schaltungsknoten a geschaltet ist. Das Versorgungspotential V_{CC} ist außerdem über einen Widerstand R3 an den Emitteranschluß eines Transistors T3 angeschlossen, ist unmittelbar an den Emitteranschluß eines Transistors T2 angeschlossen und unmittelbar an den Emitteranschluß eines Transistors T13 und ist außerdem über einen Widerstand R14 an den Emitteranschluß eines Transistors T14 geschaltet. Der Basisanschluß des Transistors T2 und der Basisanschluß des Transistors T3 sind gemeinsam an den Kollektoranschluß des Transistors T2 und außerdem an den Kollektoranschluß eines Transistors T1 angeschlossen. Der Basisanschluß des Transistors T13 und der Basisanschluß des Transistors T14 sind gemeinsam an den Kollektoranschluß des Transistors T13 und an den Kollektoranschluß eines Transistors T11 angeschlossen. Der Kollektoranschluß des Transistors T14 bildet gemeinsam mit dem Kollektoranschluß eines Transistors T12 einen Schaltungsknoten b. An den Schaltungsknoten a sind der Kollektoranschluß und der Basisanschluß eines Transistors T10, der Kollektoranschluß des Transistors T3, der Basisanchluß des Transistors T1, der Basisanschluß des Transistors T11 und der Basisanschluß des Transistors T12 angeschlossen. Der Emitteranschluß des Transistors T10 ist über die Parallelschaltung einer Induktivität L und einer Kapazität C gegen ein Bezugspotential Masse geschaltet. Der Emitteranschluß des Transistors T1 ist über einen Widerstand RA ebenfalls an das Bezugspotential Masse geschaltet. Der Emitteranschluß des Transistors T11 und der Emitteranschluß des Transistors T12 sind gemeinsam über einen Widerstand R11 an das Bezugspotential angeschlossen. Die Funktionsweise dieser bisher beschriebenen Oszillator/Demodulator-Schaltung ist detailliert in den obengenannten Offenlegungsschriften beschrieben. Der Transistor T1 und der Transistor T3 sind jeweils für den Oszillator in Emitterschaltung betrieben und bilden das aktive Element der Oszillatorschaltung, wobei jede dieser Emitterschaltungen zur Erfüllung der Phasenbedingung der Schwingungsgleichung einen Anteil von 180° liefert. Hierbei ist die Mitkopplung zwischen dem Transistor T1 und dem Transistor T3 mit Hilfe der durch den als Diode geschalteten Transistor T2 und dem Transistor T3 gebildeten Stromspiegelschaltung realisiert. An den Basisanschluß des Transistors T1 und somit den Schaltungsknoten a ist über den als Diode geschalteten Transistor T10 als frequenzbestimmendes Element ein Parallelschwingkreis, gebildet aus einer Induktivität L und einer Kapazität C angeschlossen. Der als Diode dienende Transistor T10 ist hierbei lediglich als Pegelschiebeschaltung vorgesehen, um sicherzustellen, daß bei einem unmittelbar an das Bezugspotential Masse geschalteten Parallelschwingkreis ein Anschwingen des Oszillators möglich ist. Die Transistoren T11 und T12 werden an ihrem Basisanschluß jeweils mit dem gleichen Signal angesteuert wie der Transistor T1. Der Transistor T11 prägt dem als Diode geschalteten Transistor T13 einen Strom ein, der mit dem Übersetzungsverhältnis des Emitterflächenverhältnisses der Transistoren T13 und T14 infolge der Stromspiegelschaltung auch im Iransistor T14 fließt. Das Ausgangssignal der Oszillator/Demodulator-Schaltung aus Figur 2 wird an dem Schaltungsknoten b von dem Kollektor des Transistors T14 und von dem Kollektor des Transistors T12 bereitgestellt, wobei durch geeignetes Übersetzungsverhältnis der Emitterflächen der Stromspiegeltransistoren T13 und T14 und durch geeignete Dimensionierung der Widerstände R14 und R11 erreicht werden kann, daß an dem Schaltungsknoten b dann, wenn an dem Schaltungsknoten a die Schwingungsamplitude einen bestimmten Wert übersteigt, ein niedriges Potential anliegt und dann, wenn an dem Schaltungsknoten a eine nicht so hohe Schwingungsamplitude vorliegt, ein hohes Potential am Schaltungsknoten b ansteht.

Über die bekannte Oszillator/Demodulator-Schaltung hinaus zeigt Figur 2 einen Transistor T21, dessen Kollektoranschluß an den Schaltungsknoten b angeschlossen ist und dessen Emitteranschluß an das Bezugspotential Masse geschaltet ist. Der Basisanschluß dieses Transistors T21 ist mit dem Emitteranschluß eines Transistors T22 verbunden, dessen Kollektoranschluß an das Versorgungspotential V_{CC} geschaltet ist und dessen Basisanschluß mit dem Schaltungsknoten a verbunden ist. Die Transistoren T21 und T22 bilden eine Art Darlington-Schaltung, wobei jedoch nicht die Kollektoranschlüsse der beiden Transistoren an das gleiche Potential geschaltet sind. Der Transistor T22 wird basisseitig mit dem gleichen Signal angesteuert wie die Transistoren T1,T11 und T12, sein Emitterpotential ist jedoch um die Basis-Emitterspannung des Transistors T21 höher als das Bezugspotential Masse. Dadurch ist sichergestellt, daß die durch die Transistoren T21 und T22 gebildete Darlington-Stufe erst bei Übersteigen eines bestimmten Potentiales am Schaltungsknoten a wirksam wird. Durch Abstimmen der Emitterpotentiale der Transistoren T11,T12 und des Transistors T22, was durch Wahl der durch die Transistoren T13 und T14 eingeprägten Ströme, durch Wahl der Widerstandswerte der Widerstände R11 und R14 und durch die Wahl der Basis-Emitter-Spannung des Transistors T21 - eventuell unter Zuhilfenahme weiterer Pegelschiebeeinrichtungen - variiert werden kann, läßt sich der Spannungspegel, bei dem die durch die Transistoren T21 und T22 realisierte Darlington-Schaltung wirksam wird, einstellen.

Außerdem zeigt Figur 2 einen weiteren Transistor T23, dessen Kollektoranschluß an den aus den Basisanschlüssen der Transistoren T3 und T2, dem Kollektoranschluß des Transistors T2 und dem Kollektoranschluß des Transistors T1 gebildeten Schaltungsknoten angeschlossen ist und dessen Emitteranschluß über einen Widerstand RD an das Bezugspotential Masse geschaltet ist. Der Basisanschluß dieses Transistors T23 ist, wie der Basisanschluß des Tranistors T21, mit dem Emitteranschluß des Transistors T22 verbunden und bildet somit auf die gleiche Weise wie der Transistor T21 mit dem Transistor T22 eine Darlington-Schaltung. Auch diese Darlington-Schaltung wird erst wirksam, wenn das Potential an dem Schaltungsknoten a einen bestimmten Pegel übersteigt. Wenn die Darlington-Stufe, gebildet aus dem Transistor T22 und dem Transistor T23 wirksam wird, so wird der aus den Transistoren T1, T2 und T3 gebildete Oszillator bedämpft. Der Grad der Beeinflussung der Oszillatorschaltung durch die Darlington-Stufe, gebildet aus den Transistoren T23 und T22 ist durch Wahl des Widerstandes RD variierbar. Bezüglich des Potentialwertes am Schaltungsknoten a, bei dem die durch die Transistoren T22 und T23 gebildete Darlington-Stufe wirksam wird, gelten die Ausführungen zu der aus den Transistoren T21 und T22 gebildeten Darlington-Stufe entsprechend.

Der Ausgangsstrom einer Stromspiegelschaltung, also beispielsweise der Kollektorstrom des Transistors T14 in der Demodulatorstufe oder der Kollektorstrom des Transistors T3 in der Oszillatorschaltung steigt mit wachsender Temperatur an. Da die Stromspiegelschaltung, gebildet aus den Transistoren T13 und T14, mit größer werdendem Strom ein größeres Ausgangssignal liefert, ist das Temperaturverhalten der beschriebenen Demodulatorschaltung geeignet, das Temperaturverhalten einer Spule mit Ferritkern für Temperaturen unterhalb des Maximums der Güte dieser Spule zu kompensieren. Das gleiche gilt für die Stromspiegelschaltung, gebildet aus den Transistoren T2 und T3, in Bezug auf die Oszillatorschaltung. Das Maximum der Güte von für induktive Annäherungsschalter geeigneten Spulen liegt bei etwa 255°C bis 50°C.

Das Temperaturverhalten einer Darlington-Schaltung, wie sie aus den Transistoren T21 und T22 und auch aus den Transistoren T23 und T22 gebildet wird, ist derart, daß mit steigender Temperatur die zum Durchsteuern der Darlington-Stufen erforderliche Basis-Emitter-Spannung kleiner wird. Daher ist das Temperaturverhalten dieser Darlington-Stufe, gebildet aus den Transistoren T21 und T22 bzw. T22 und T23 geeignet, das Temperaturverhalten einer Spule mit Ferritkern für Temperaturen oberhalb der Temperatur, bei der die Güte dieser Spule maximal ist, zu kompensieren. Wenn die erfindungsgemäße Schaltung nach Figur 2 derart dimensioniert ist, daß die Darlington-Schaltung, bestehend aus den Transistoren T21 und T22 bzw. den Transistoren T22 und T23, im Bereich der Temperatur, bei der die Güte der Spule mit Ferritkern maximal ist, im Schaltpunkt des Demodulators einsetzt, so führt die Überlagerung der Temperaturcharakteristik der Demodulatorschaltung, insbesondere der Transistoren T13 und T14 sowie der Oszillatorschaltung latorschaltung und der Temperaturcharakteristik der Darlington-Schaltung, gebildet aus den Transistoren T21 und T22 sowie der Darlington-Schaltung, gebildet aus den Transistoren T22 und T23, ab dem Einsetzen der Darlington-Schaltungen zu einer Gesamttemperaturcharakteristik, die geeignet ist, die Temperaturcharakteristik der Güte der Spule mit Ferritkern zu kompensieren. Hierbei kann durch geeignete Wahl der Stromverstärkung der einzelnen Darlington-Schaltungen und durch Variation des Widerstandes RD die Temperaturcharakteristik in geeigneter Weise abgestimmt werden.

Der Transistor T22 sollte möglichst bei Erreichen des Potentialwertes am Schaltungsknoten a leitend werden, bei dem das Ausgangssignal der Demodulatorstufe zwischen einem hohen und einem niedrigen Pegel wechselt, und zwar speziell bei der Temperatur, bei der die Spule mit Ferritkern die größte Güte aufweist. Wenn der Transistor T22 sperrt, sperrt auch der Transistor T21 und ist deshalb für den Schaltungsknoten b und somit für den Signalausgang der Oszillator/Demodulator-Schaltung unwirksam. Der logische Zustand des Ausgangssignales der Oszillator/Demodulator-Schaltung ist dann nur davon abhängig, ob der Kollektorstrom des Transistors T14 größer oder kleiner als der Kollektorstrom des Transistors T12 ist bzw., ob in Abhängigkeit von dem Potential am Schaltungsknoten a die durch das Emitterflächenverhältnis der Transistoren T13 und T14 bewirkte Verstärkung größer ist, als die durch den Widerstand R14 bewirkte, mit wachsendem Stromspiegelstrom größer werdende Potentialabsenkung am Emitter des Transistors T14. Wenn der Transistor T22 leitet, wird dem Schaltungsknoten b über den Kollektoranschluß des Transistors T21 ein Strom entnommen, der durch den Emitterstrom des Transistors T22 und die Stromverstärkung des Transistors T21 festgelegt ist. Dieser Strom hat bezüglich des Schaltungsknotens b das gleiche Vorzeichen wie der Kollektorstrom des Transistors T12 bzw. das entgegengesetzte Vorzeichen des Kollektorstromes des Transistors T14. Dadurch wird der Schaltpunkt, der von der Oszillator/Demodulator-Schaltung festgelegt wird, verschoben. Gleichzeitig mit dem Transistor T21 wird auch der Transistor T23 durch den Transistor T22 gesteuert. Wenn der Transistor T23 sperrt, ist er für die Verstärkung und somit die Signalamplitude der Oszillatorstufe unwirksam. Wenn der Transistor T23 in dem Temperaturbereich, bei dem die Güte des Schwingkreises LC des Oszillators ein Maximum hat, im Schaltpunkt zu leiten beginnt, erhöht sein Kollektorstrom den Strom in dem Transistor T2 und infolge der Stromspiegelschaltung auch den Strom im Transistor T3. Der dadurch bewirkte zusätzliche Kollektorstrom des Transistors T3 fließt über die Diode T10 in die Spule L des Schwingkreises LC und verschiebt somit den Schaltpunkt des Annäherungsschalters. Diese Verschiebung des Schaltpunktes wirkt oberhalb der Temperatur, bei der die Güte einer Spule mit Ferritkern ein Maximum hat, der temperaturabhängigen Verschiebung des Schaltpunktes, die durch die Temperaturabhängigkeit der Güte einer Spule mit Ferritkern bedingt ist, entgegen.

In Figur 2 wird eine Schaltungsvariante beschrieben, bei der sowohl die Oszillatorverstärkerschaltung als auch die Demodulatorschaltung derart angepaßt wurden, daß ihre temperaturabhängigen Auswirkungen auf den Schaltpunkt des Annäherungsschalters der durch die Temperaturabhängigkeit der Güte des Schwingkreises des Oszillators bedingten Temperaturabhängigkeit des Schaltpunktes des Annäherungsschalters entgegenwirkt. Es würde jedoch auch ausreichen, wenn entweder der Oszillatorverstärker oder der Demodulator entsprechend angepaßt werden.

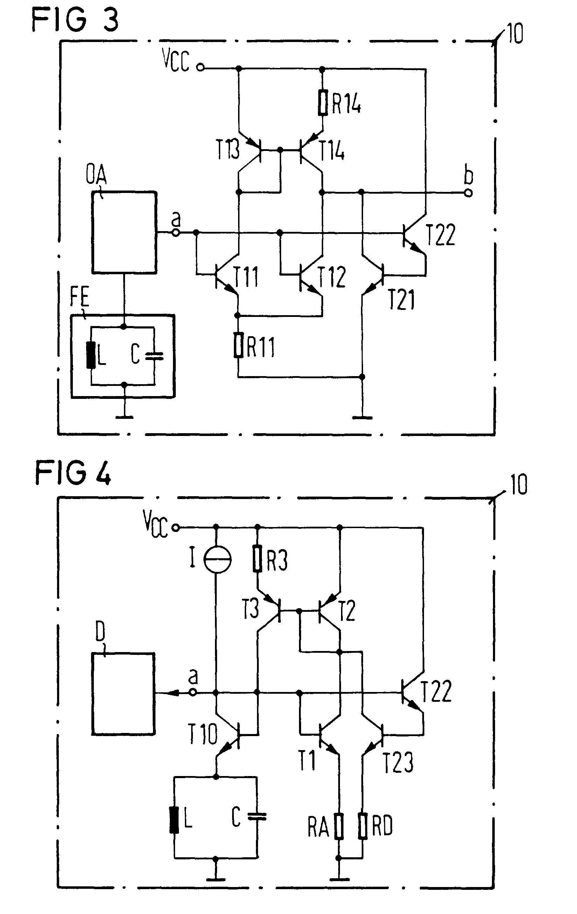

Figur 3 zeigt als Blockschaltbild eine Oszillatorverstärkerschaltung OA mit einem Schwingkreis FE, der insbesondere aus einer Induktivität L und einer hierzu parallel geschalteten Kapazität C besteht und gegen das Bezugspotential Masse geschaltet ist. Der Oszillatorverstarker OA ist an einen Schaltungsknoten a angeschlossen, der außerdem mit den Basisanschlüssen eines Transistors T11, eines Transistors T12 und eines Transistors T22 zusammengeschaltet ist. Die Emitteranschlüsse der Transistoren T11 und T12 sind gemeinsam über einen Widerstand R11 an das Bezugspotential Masse geschaltet. Der Emitteranschluß des Transistors T22 ist an den Basisanschluß eines Transistors T21 angeschlossen, dessen Emitteranschluß an das Bezugspotential Masse geschaltet ist. Der Kollektoranschluß des Transistors T11 ist mit dem Kollektoranschluß und dem Basisanschluß eines Transistors T13 und außerdem mit dem Basisanschluß eines Transistors T14 verbunden. Der Transistor T13 ist hierbei als Diode geschaltet und unterscheidet sich vom Transistor T14 unter anderem in der Emitterflächengröße. Der Emitteranschluß des Transistors T13 sowie der Kollektoranschluß des Transistors T22 sind unmittelbar an ein Versorgungspotential V_{CC} geschaltet. Der Emitteranschluß des Transistors T14 ist über einen Widerstand R14 an das Versorgungspotential V_{CC} angeschlossen. Der Kollektoranschluß des Transistors T12, der Kollektoranschluß des Transistors T14 und der Kollektoranschluß des Transistors T21 bilden einen Schaltungsknoten b, der den Signalausgang der beschriebenen Demodulatorschaltung darstellt. Der Schaltungsaufbau der in Figur 3 beschriebenen Demodulatorschaltung unterscheidet sich nicht von dem Schaltungsaufbau der in Figur 2 gezeigten Demodulatorschaltung. Auch die Funktionsweise ist identisch.

Diese in Figur 3 beschriebene Demodulatorschaltung ist geeignet, in Verbindung mit irgendeinem bekannten Oszillatorverstärker OA die durch die Temperaturabhängigkeit der Güte des Schwingkreises FE bedingte Temperaturabhängigkeit des Schaltpunktes eines damit realisierten induktiven Annäherungsschalters zu kompensieren.

Figur 4 zeigt die in Figur 2 beschriebene Oszillatorschaltung, bestehend aus einer Stromquelle I, die zwischen einem Versorgungspotential V_{CC} und einem Schaltungsknoten a angeordnet ist. An den Schaltungsknoten a ist eine beliebige Demodulatorschaltung D angeschlossen. Außerdem verbindet der Schaltungsknoten a den Kollektoranschluß und den Basisanschluß eines Transistors T10, den Kollektoranschluß eines Transistors T3, den Basisanschluß eines Transistors T1 und den Basisanschluß eines Transistors T22 miteinander. Der Emitteranschluß des Transistors T1 ist über einen Widerstand RA an das Bezugspotential Masse geschaltet. Der Emitteranschluß des Transistors T10, der als Diode geschaltet ist, ist über die Parallelschaltung eines Kondensators C und einer Induktivität L an das Bezugspotential Masse geschaltet. Der Kollektoranschluß des Transistors T1 ist mit dem Kollektoranschluß eines Transistors T3 und dem Kollektoranschluß eines Transistors T21 zusammengeschaltet und außerdem mit dem Basisanschluß des Transistors T2 und mit dem Basisanschluß des Transistors T3 verbunden. Die Transistoren T2 und T3 bilden somit eine Stromspiegelschaltung, wobei der Emitteranschluß des Transistors T2 unmittelbar an das Versorgungspotential V_{CC} geschaltet ist und der Emitteranschluß des Transistors T3 über einen Widerstand R3 an dieses Versorgungspotential V_{CC} geschaltet ist. Der Basisanschluß des Transistors T23 ist mit dem Emitteranschluß des Transistors T22 zusammengeschaltet und bildet mit diesem eine Darlington-Stufe. Der Emitteranschluß des Transistors T23 ist über einen Widerstand RD an das Bezugspotential Masse geschaltet. Der Widerstand RD ist hierbei hierbei für die Funktionsweise der Schaltung nicht erforderlich. durch Variation dieses Widerstandes RD - evtl auch 0 Ohm - kann jedoch die durch die Darlington-Stufe T22,T23 bedingte Temperaturabhängigkeit des Schaltpunktes des Annäherungsschalters an die durch den Schwingkreis bedingte Temperaturabhängigkeit des Schaltpunktes individuell angepaßt werden. Der Kollektoranschluß des Transistors T22 ist an das Versorgungspotential V_{CC} geschaltet.

Die Funktionsweise einer solchen Oszillatorschaltung insbesondere bezüglich der Temperaturkompensation ist oben, bei der Beschreibung der Figur 2 erläutert. Auch diese Schaltung ist geeignet, die durch die Güte des Schwingkreises LC bedingte Temperaturabhängigkeit des Schaltpunktes eines damit realisierten induktiven Annäherungsschalters 1 zu kompensieren.

## Patentansprüche

1. Induktiver Annäherungsschalter (1), umfassend:
- einen Anwesenheitsindikator (10), der einen Oszillator mit Schwingkreis (L, C) und einen Oszillatorverstärker (T1, T2, T3) enthält und der eine Temperaturabhängigkeit aufweist, durch die die durch die Temperaturabhängigkeit der Güte des Schwingkreises bedingte Temperaturabhängigkeit des Schaltpunktes des induktiven Näherungsschalters ausgleichbar ist,
- einen dem Oszillator zugeordneten Demodulator (T11, T12, T13, T14),
- einen vom Anwesenheitsindikator gesteuerten Schaltverstärker (11),
- einen vom Anwesenheitsindikator über den Schaltverstärker steuerbaren elektronischen Schalter (14),
**dadurch gekennzeichnet**, daß
der Oszillatorverstärker (T1, T2, T3) eine Stromspiegelschaltung (T2, T3) umfaßt und eine Darlington-Stufe (T22, T23), daß durch die Darlington-Stufe in den gesteuerten Zweig (T2) der Stromspiegelschaltung des Oszillatorverstärkers ein Strom eingekoppelt wird und daß die Darlington-Stufe von einem am Oszillator (L, C) abgreifbaren Potential (a) steuerbar ist.

2. Induktiver Annäherungsschalter (1), umfassend:
- einen Anwesenheitsindikator (10), der einen Oszillator mit Schwingkreis (L, C) und einen Oszillatorverstärker (T1, T2, T3) enthält und der eine Temperaturabhängigkeit aufweist, durch die die durch die Temperaturabhängigkeit der Güte des Schwingkreises bedingte Temperaturabhängigkeit des Schaltpunktes des induktiven Näherungsschalters ausgleichbar ist,
- einen dem Oszillator zugeordneten Demodulator (T11, T12, T13, T14),
- einen vom Anwesenheitsindikator gesteuerten Schaltverstärker (11),
- einen vom Anwesenheitsindikator über den Schaltverstärker steuerbaren elektronischen Schalter (14),
**dadurch gekennzeichnet**, daß
der Demodulator (T11, T12, T13, T14) eine Stromspiegelschaltung (T13, T14) umfaßt und eine Darlington-Stufe (T22, T21), daß durch die Darlington-Stufe in den gesteuerten Zweig (T14) der Stromspiegelschaltung des Demodulators ein Strom eingekoppelt wird und daß die Darlington-Stufe von einem am Oszillator (L, C) abgreifbaren Potential (a) steuerbar ist.

3. Induktiver Annäherungsschalter mit den Merkmalen der Ansprüche 1 und 2.

4. Induktiver Annäherungsschalter nach einem der Ansprüche 1 bis 3,
**dadurch gekennzeichnet**, daß
die Darlington-Stufe einen ersten Transistor (22) umfaßt, dessen Basis-Anschluß einen Steuereingang der Darlington-Stufe bildet und einen zweiten Transistor (21, 23), über dessen Basis-Emitter-Strompfad der Emitter des ersten Transistors (22) an einen Anschluß für Bezugspotential gekoppelt ist, daß der Kollektor des ersten Transistors (22) mit einem Anschluß für ein Versorgungspotential (VCC) verbunden ist und daß über den Kollektor des zweiten Transistors (21, 23) der Strom in den jeweiligen Stromspiegel einkoppelbar ist.

5. Induktiver Annäherungsschalter nach Anspruch 4, sofern rückbezogen auf Anspruch 3,
**dadurch gekennzeichnet**, daß
der erste Transistor (22) der Darlington-Stufen ein beiden Darlington-Stufen gemeinsamer einziger Transistor ist.

## Claims

1. Inductive proximity switch (1), comprising:
- a presence indicator (10), which contains an oscillator, having a resonant circuit (L, C), and an oscillator amplifier (T1, T2, T3) and has a temperature dependence by means of which it is possible to compensate for the temperature dependence, which is dictated by the temperature dependence of the quality of the resonant circuit, of the switching point of the inductive proximity switch,
- a demodulator (T11, T12, T13, T14) assigned to the oscillator,
- a switching amplifier (11) controlled by the presence indicator,
- an electronic switch (14) which can be controlled by the presence indicator via the switching amplifier,
characterized in that the oscillator amplifier (T1, T2, T3) comprises a current mirror circuit (T2, T3) and a Darlington stage (T22, T23), in that a current is coupled by the Darlington stage into the controlled branch (T2) of the current mirror circuit of the oscillator amplifier, and in that the Darlington stage can be controlled by a potential (a) which can be picked off at the oscillator (L, C).

2. Inductive proximity switch (1), comprising:
- a presence indicator (10), which contains an oscillator, having a resonant circuit (L, C), and an oscillator amplifier (T1, T2, T3) and has a temperature dependence by means of which it is possible to compensate for the temperature dependence, which is dictated by the temperature dependence of the quality of the resonant circuit, of the switching point of the inductive proximity switch,
- a demodulator (T11, T12, T13, T14) assigned to the oscillator,
- a switching amplifier (11) controlled by the presence indicator,
- an electronic switch (14) which can be controlled by the presence indicator via the switching amplifier,
characterized in that the demodulator (T11, T12, T13, T14) comprises a current mirror circuit (T13, T14) and a Darlington stage (T22, T21), in that a current is coupled by the Darlington stage into the controlled branch (T14) of the current mirror circuit of the demodulator, and in that the Darlington stage can be controlled by a potential (a) which can be picked off at the oscillator (L, C).

3. Inductive proximity switch having the features of Claims 1 and 2.

4. Inductive proximity switch according to one of Claims 1 to 3, characterized in that the Darlington stage comprises a first transistor (22), the base connection of which forms a control input of the Darlington stage, and a second transistor (21, 23), via the base/emitter current path of which the emitter of the first transistor (22) is coupled to a connection for reference potential, in that the collector of the first transistor (22) is connected to a connection for a supply potential (VCC), and in that the current can be coupled into the respective current mirror via the collector of the second transistor (21, 23).

5. Inductive proximity switch according to Claim 4, provided that reference is made back to Claim 3, characterized in that the first transistor (22) of the Darlington stages is a single transistor common to both Darlington stages.

## Revendications

1. Interrupteur inductif de proximité (1) comprenant :
- un indicateur de présence (10), qui contient un oscillateur possédant un circuit oscillant (L,C) et un amplificateur (T1,T2,T3) de l'oscillateur, et qui possède une dépendance vis-à-vis de la température, sur la base de laquelle peut être compensée la dépendance du point de commutation de l'interrupteur de proximité inductif vis-à-vis de la température, dépendance qui est conditionnée par la dépendance du facteur de qualité du circuit oscillant vis-à-vis de la température,
- un démodulateur (T11,T12,T13,T14) associé à l'oscillateur,
- un amplificateur de commutation (11) commandé par l'indicateur de présence,
- un interrupteur électronique (14) commandable par l'indicateur de présence par l'intermédiaire de l'amplificateur de commutation,
caractérisé par le fait
que l'amplificateur (T1,T2,T3) de l'oscillateur comprend un circuit formant miroir de courant (T2,T3) et un étage de Darlington (T22,T23),
qu'un courant est injecté par l'étage de Darlington dans la branche commandée (T2) du circuit formant miroir de courant de l'amplificateur de l'oscillateur et que l'étage de Darlington peut être commandé par un potentiel (a) pouvant être prélevé sur l'oscillateur (L,C).

2. Interrupteur inductif de proximité (1), comportant :
- un indicateur de présence (10), qui contient un oscillateur possédant un circuit oscillant (L,C) et un amplificateur (T1,T2,T3) de l'oscillateur, et qui possède une dépendance vis-à-vis de la température, sur la base de laquelle peut être compensée la dépendance du point de commutation de l'interrupteur de proximité inductif vis-à-vis de la température, dépendance qui est conditionnée par la dépendance du facteur de qualité du circuit oscillant vis-à-vis de la température,
- un démodulateur (T11,T12,T13,T14) associé à l'oscillateur,
- un amplificateur de commutation (11) commandé par l'indicateur de présence,
- un interrupteur électronique (14) commandable par l'indicateur de présence par l'intermédiaire de l'amplificateur de commutation,
caractérisé par le fait
que le démodulateur (T11,T12,T13,T14) comprend un circuit formant miroir de courant (T13,T14) et un étage de Darlington (T22,T21), qu'un courant est injecté par l'étage de Darlington dans la branche commandée (14) du circuit formant miroir de courant du démodulateur et que l'étage de Darlington peut être commandé par un potentiel (a) pouvant être prélevé sur l'oscillateur (L,C).

3. Interrupteur inductif de proximité présentant les caractéristiques des revendications 1 et 2.

4. Interrupteur inductif de proximité suivant l'une des revendications 1 à 3, caractérisé par le fait que l'étage de Darlington comporte un premier transistor (22), dont la borne de base forme une entrée de commande de l'étage de Darlington, et un second transistor (21,23), par l'intermédiaire de la voie de courant base - émetteur duquel l'émetteur du premier transistor (22) est couplé à une borne pour le potentiel de référence, que le collecteur du premier transistor (22) est relié à une borne pour un potentiel d'alimentation (VCC) et que le courant peut être injecté dans le miroir de courant respectif, par l'intermédiaire du collecteur du second transistor (21,23).

5. Interrupteur inductif de proximité suivant la revendication 4, dans la mesure où elle est considérée comme dépendante de la revendication 3, caractérisé par le fait que le premier transistor (22) des étages de Darlington est un transistor unique commun aux deux étages de Darlington.
